# EUROPEAN PATENT APPLICATION

(11) **EP 0 881 499 A2**
(43) Date of publication of application: **02.12.1998**
(21) Application number: 98109855.1
(22) Date of filing: 29.05.1998
(51) Int. Cl.: G01R 25/00

(54) **Semiconductor integrated circuit including phase locked loop circuit and jitter detector**

(30) Priority: 30.05.1997 JP 141830/97
(71) Applicant: NEC CORPORATION, Tokyo (JP)
(72) Inventor: Uto, Yoshiyuki, NEC IC Microcomputer Systems, Ltd., Kawasaki-shi, Kanagawa (JP)
(74) Representative: Betten & Resch

(57) **Abstract**

The present invention provides a jitter detector 40 suitable for measuring the jitter in output signals of a PLL circuit 30 and a semiconductor integrated circuit 50 including the PLL circuit 30 and the jitter detector 40. The jitter detector 40 detects whether the amount of jitter (,or the phase difference between a first and a second signals) is smaller than the predetermined acceptable value in the products test. The jitter detector comprises a delay circuit (41 or 42) receiving the first signal (101 or 105) and delaying the first signal corresponding with the predetermined acceptable value to generate a first delayed signal (106 or 107), and a latch circuit (43 or 44) latching a level of the first delayed signal corresponding with a rising edge of the second input signal (105 or 101) to generate a detect signal (108 or 109). The detect signal represents a result of test.

## Description

### BACKGROUND OF THE INVENTION

### Field of the Invention

The present invention relates to a semiconductor integrated circuit, and in particular, a semiconductor integrated circuit includes a jitter detector detecting the amount of jitter in an output signal of a phase locked loop (hereinafter referred to as a "PLL") circuit.

### Description of the Prior Art

In general, a PLL circuit generates an output signal (a phase lock signal) synchronizing with an input signal. The output signal has the same frequency as the input signal. The PLL circuit includes a phase comparator, a low-pass filter (hereinafter referred to as a "LPF") and a voltage controlled oscillator (hereinafter referred to as a "VCO"). The phase comparator compares a phase of the input signal to the output signal and generates a phase difference signal corresponding with the amount of phase difference between the input and output signals. The phase difference signal is inputted to the VCO through the LPF. Then, the VCO generates the output signal corresponding to an output of the LPF. Also, the output signal is fed back to the phase comparator.

The output signal of the PLL circuit has a jitter which is a minute phase difference between the input and output signals. To measure the amount of jitter, each of the frequency of the input and output signals is measured at outside the semiconductor integrated circuit using a frequency meter. The amount of jitter is obtained from a period difference between the input and output signals.

In the products test, if the amount of jitter is larger than a predetermined acceptable value, the semiconductor integrated circuit is determined to be rejected.

The conventional method for measuring the amount of jitter requires the frequency meter that is an exclusive measuring device and wiring from the output terminals of the semiconductor integrated circuit for the input and output signals to the frequency meter. Thus, measurement operations are complicated, skew may occur in the frequency meter, and signals may be delayed due to the wiring. In addition, measurements cannot be executed accurately due to extraneous noise in the wiring. Furthermore, a manual or other means must be used to determine whether the amount of jitter is within the predetermined acceptable value, based on the results of the measurement of frequency.

### SUMMARY OF THE INVENTION

It is, therefore, an object of the present invention to provide a jitter detector measuring the amount of jitter in signals.

It is another object of the present invention to provide a semiconductor integrated circuit including a PLL circuit that can simply detect whether the semiconductor integrated circuit is pass or rejection.

To achieve this object, a jitter detector according to the present invention is a device for detecting whether an amount of jitter is smaller than a predetermined value, the amount of jitter being defined as a period between a rising edge of a first input signal and a rising edge of a second input signal, the jitter detector comprising:
a first delay circuit receiving the first input signal and delaying the first input signal corresponding with the predetermined value to generate a first delayed signal;
a second delay circuit receiving the second input signal and delaying the second input signal corresponding with the predetermined value to generate a second delayed signal;
a first latch circuit latching a level of the first delayed signal corresponding with the rising edge of the second input signal to generate a first detect signal; and
a second latch circuit latching a level of the second delayed signal corresponding with the rising edge of the first input signal to generate a second detect signal.

Also, a semiconductor integrated circuit according to this invention comprising a phase locked loop circuit receiving an input signal and generating an output signal synchronizing with the input signal, a jitter detector detecting whether a phase difference between the input signal and the output signal is smaller than a predetermined value or not. In this connection, the phase locked loop circuit and the jitter detector is formed on one chip semiconductor device.

According to the jitter detector according to the present invention can determine whether the phase difference between a first and a second input signals is within a predetermined time, that is, whether there is a predetermined amount of jitter in the output signal of the PLL circuit. Also, the amount of jitter can be known by the delay value in the delay circuit being adjusted.

### BRIEF DESCRIPTION OF THE DRAWINGS

This above-mentioned and other objects, features and advantages of this invention will become more apparent by reference to the following detailed description of the invention taken in conjunction with the accompanying drawings, wherein:
Fig. 1 is a block diagram of a semiconductor integrated circuit according to the present invention;
Fig. 2 is a timing chart showing a case in which the amount of jitter is smaller than a delay value from a first delay circuit;
FIG. 3 is a timing chart showing a case in which the amount of jitter is larger than the delay value from the first delay circuit;
FIG. 4 is a timing chart showing a case in which the amount of jitter is smaller than a delay value from a second delay circuit;
FIG. 5 is a timing chart showing a case in which the amount of jitter is larger than the delay value from the second delay circuit; and
FIG. 6 is a block diagram of a semiconductor integrated circuit according to a prior art.

### DETAILED DESCRIPTION OF THE PREFERRED EMBODIMENTS

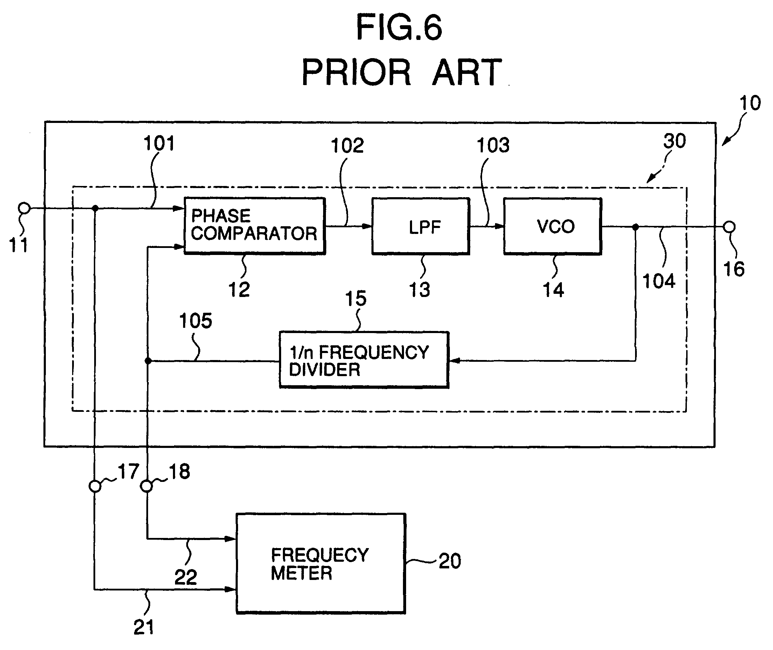

Referring now to FIG. 6, there is shown a block diagram of a conventional semiconductor integrated circuit 10 including a PLL circuit 30. The PLL circuit 30 including a phase comparator 12, a LPF 13, a VCO 14, and a 1/n frequency divider 15. An input signal 101 having a reference frequency is inputted to the phase comparator 12. The phase comparator 12 compares the input signal 101 and the divided signal 105 (as describe later) and generates a phase difference signal 102. The phase comparator 12 supplies the phase difference signal 102 to the LPF 13, by which an oscillation control signal 103 is produced. The VCO 14 is controlled in frequency by the oscillation control signal 103 to generate the output signal 104 having an output frequency which is "n" times as much as the reference frequency of the input signal 101. The output signal 104 is outputted through the output terminal 16 to another device. The 1/n frequency divider 15 divides the output frequency of the output signal 104 so as to become the same frequency as the reference frequency of the input signal 101 and thus outputs a divided signal 105. In short, the divided signal 105 becomes the same as the input signal 101 theoretically. However, in fact, a phase of the input signal 101 differs from the divided signal 105 slightly. A phase difference is represented as the jitter. To measure the amount of jitter, a frequency meter 20 is connected to the semiconductor integrated circuit 10 through output terminals 17, 18 and wirings 21, 22. In this case, the output terminal 17 and the wiring 21 supplies the input signal 101 to the frequency meter 20, the output terminal 18 and the wiring 22 supplies the divided signal 105 to the frequency meter 20. Each of frequency of the input signal 101 and the divided signal 105 is measured by the frequency meter 20. As a result, the amount of period difference between the frequency of the input signal 101 and the frequency of the divided signal 105 is obtained. Then, an examiner compares the period of the input signal 101 with the period of the divided signal 105 and confirms whether the amount of period difference (,or jitter) is within the predetermined acceptable value.

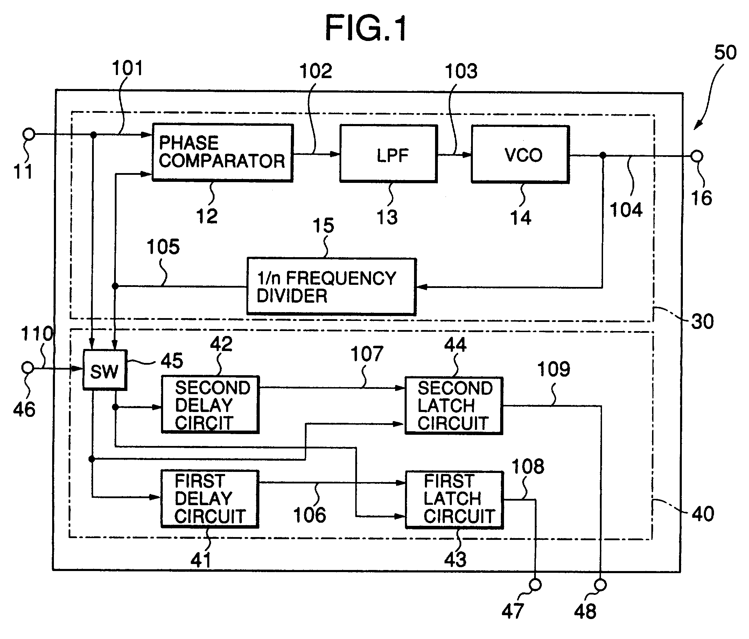

Referring now to Fig. 1, there is shown a semiconductor integrated circuit 50 in accordance with an embodiment of the present invention, in which the same constituents as those shown in Fig. 1 are denoted by the same reference numerals or symbols to omit the further description thereof.

In this circuit 50, there is provided a jitter detector 40 detecting whether a jitter is within the predetermined acceptable value. A PLL circuit 30 similar to a conventional semiconductor integrated circuit 10. The jitter detector 40 includes a first delay circuit 41, a second delay circuit 42, a first latch circuit 43, a second latch circuit 44, and a switching circuit 45. Such as the delay circuit may be comprised by a timer or inverter circuits.

A test terminal 46 receives a test-mode signal 110 and supplies it to the switching circuit 45. When the products test is executed, a test-mode signal 110 becomes an active level. In this connection, the test-mode signal becomes active level after a frequency of the output signal 104 becomes stability. The switching circuit 45 supplies the input signal 101 and the divided signal 105 to the first delay circuit 41 and the second delay circuit 42 respectively corresponding with the active level of the test-mode signal 110. The first delay circuit 41 delays the input signal 101 corresponding with the predetermined acceptable value and outputs a first delayed signal 106. Similarly, the second delay circuit 42 delays the divided signal 105 corresponding with the predetermined acceptable value and outputs a second delayed signal 107. In short, the delay value in each of the first and second delay circuits 41 and 42 is set in accordance with the predetermined acceptable value. The first latch circuit 43 latches the first delayed signal 106 corresponding with a rising edge of the divided signal 105 and outputs a latched logic level of the first delayed signal 106 as the first detect signal 108. The second latch circuit 44 latches the second delayed signal 107 corresponding with a rising edge of the input signal 101 and outputs a latched logic level of the second delayed signal 107 as the second detect signal 109. A first result output terminal 47 and a second result output terminal 48 supplies the first detect signal 108 and the second detect signal 109 to another device respectively.

The amount of jitter can be defined as the amount of variation of the period of the divided signal 105. When the phase of the input signal 101 is used as a reference, the phase difference between the input signal 101 and the divided signal 105 can be referred to as the amount of jitter in the divided signal 105. This definition is used below.

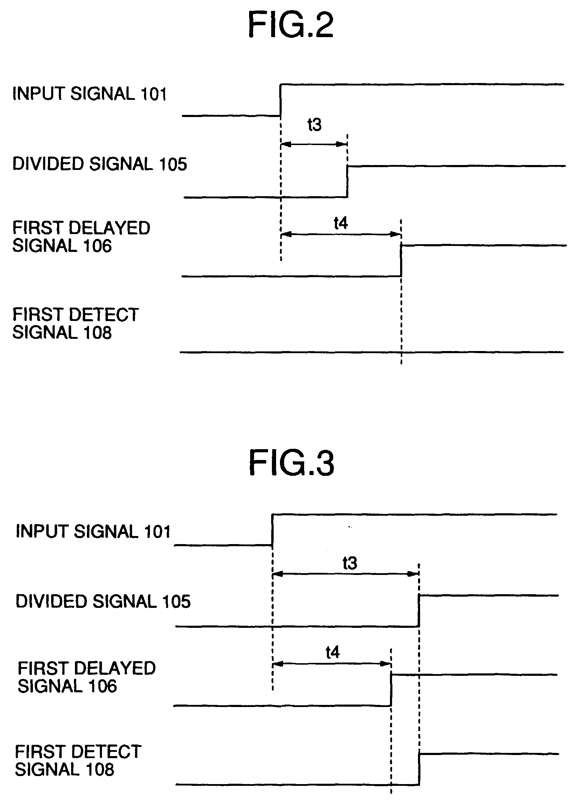

Referring now to Figs. 2 and 3, there is a timing chart showing a case in which the phase of the divided signal 105 lags behind the phase of the input signal 101. More particularly, Fig. 2 is a case in which the amount of jitter t3 is smaller than the delay value t4 in the first delay circuit 41, and Fig. 3 is a case in which the amount of jitter t3 is larger than the delay value t4.

Referring now to Fig. 2, the first detect signal 108 is "0" (low-level) initially. The input signal 101 is delayed the period t4, so that the first delayed signal 106 becomes "1" (high-level) after the divided signal 105 becomes "1". Accordingly, the level of the first detect signal 108 maintains "0".

Referring now to Fig. 3, the input signal 101 is delayed the period t4, so that the first delayed signal 106 becomes "1" before the divided signal 105 becomes "1". Accordingly, the level of the first detect signal 108 changed to "1".

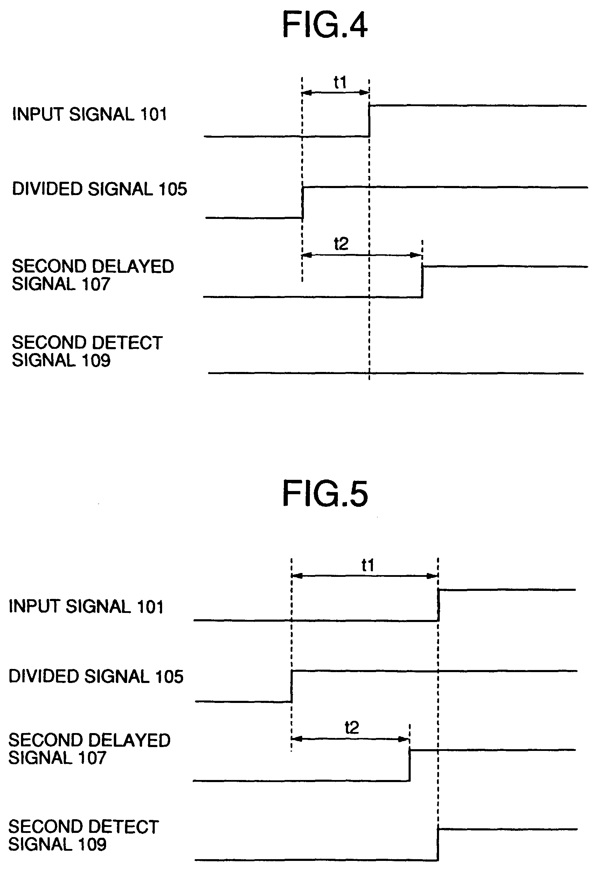

Referring now to Figs. 4 and 5, there is a timing chart showing a case in which the phase of the divided signal 105 is in advance of the phase of the input signal 101. More particularly, Fig. 4 is a case in which the amount of jitter t1 is smaller than the delay value t2 in the second delay circuit 42, and Fig. 5 is a case in which the amount of jitter t1 is larger than the delay value t2.

Referring now to Fig.4, the second detect signal 109 is "0" initially. The divided signal 105 is delayed the period t2, so that the second delayed signal 107 becomes "1" after the input signal 101 becomes "1". Accordingly, the level of the second detect signal 109 maintains "0".

Referring now to Fig. 5, the divided signal 105 is delayed the period t2, so that the second delayed signal 107 becomes "1" before the input signal 101 becomes "1". Accordingly, the level of the second detect signal 109 changed to "1".

Each of the first and second detect signal 108 and 109 is becomes "0" or "1" in accordance with the amount of jitter (t1 or t3) and the amount of delay value in the delay circuit (t2 or t4). Accordingly, there are obtained four states A to D as indicated in the following TABLE-1 in accordance with the relationship between the amounts t1, t2 t3 and t4.

**TABLE-1**

| STATE | Logical level of the first detect signal 108 | Logical level of the second detect signal 109 | Relationship between the amounts |
|---|---|---|---|
| A | 0 | 0 | t1<t2 t3<t4 |
| B | 0 | 1 | t1>t2 t3<t4 |
| C | 1 | 0 | t1<t2 t3>t4 |
| D | 1 | 1 | t1>t2 t3>t4 |

In state A, both amounts of jitter t1 and t3 are smaller than the delay values t2 and t4. In this case, each of the first and second detect signals 108 and 109 becomes "0", so the semiconductor integrated circuit 50 are determined to be passed. In state B, the amount of jitter t1 is larger than the delay value t2 and the amount of jitter t3 is smaller than the delay value t4. In this case, the first detect signal 108 becomes "0", however, the second detect signal 109 becomes "1". Therefore, the semiconductor integrated circuit 50 is determined to be rejected. In state C, the amount of jitter t1 is smaller than the delay value t2 and the amount of jitter t3 is larger than the delay value t4. In this case, the second detect signal 109 becomes "0", however, the first detect signal 108 becomes "1". Therefore, the semiconductor integrated circuit 50 is determined to be rejected. In state D, both the amounts of jitter t1 and t3 are larger than the delay values t2 and t4. In this case, both the signals 108 and 109 becomes "1", so the semiconductor integrated circuit 50 is determined to be rejected.

As described above, when either the first detect signal 108 or the second detect signal 109 is becomes "1", the semiconductor integrated circuit 50 is determined to be rejected.

In the semiconductor integrated circuit 50 of the present invention, the jitter detector 40 provided inside the circuit 50 operate to detect whether the amount of jitter is smaller than the predetermined acceptable value or not. Accordingly, the semiconductor integrated circuit 50 outputs the results of the products test. Consequently, since the acceptability of the semiconductor integrated circuit 50 can be determined simply by monitoring the results, the present invention is unlikely to be affected by skew in the frequency meter or extraneous noise that may enter external wiring, compared with the conventional semiconductor integrated circuit 10 in which the amount of jitter is measured using the frequency meter 20 from outside the circuit 10. Accordingly, the acceptability of the semiconductor integrated circuit 50 of the present invention can be determined accurately and stably. In addition, the acceptability of the amount of jitter can be determined during the normal sorting step in the production line.

Since the first and second delay circuit 41 and 42 and the first and second latch circuits 43 and 44 can be configured easily using transistor circuits in the semiconductor integrated circuit 50, the amount of jitter can be measured with accuracy in the order of 1 ns despite the manufacturing variation of transistor circuits. In this connection, the PLL circuit 30 and the jitter detector 40 are formed on one semiconductor chip. In other words, the semiconductor integrated circuit 50 of the present invention represents one chip semiconductor device.

As described above, the jitter detector 40 of the present invention can determine whether the phase difference between a first and a second signals is within a predetermined time, that is, whether there is a predetermined amount of jitter in the output signal of the PLL circuit. Also, the amount of jitter can be known by the delay value in the delay circuit being adjusted.

It is apparent that the present invention is not limited to the illustrated embodiment, but may be modified and changed without departing from the scope and spirit of the invention.

## Claims

1. A jitter detector detecting whether an amount of jitter is smaller than a predetermined value, said amount of jitter being defined as a period between a rising edge of a first input signal and a rising edge of a second input signal, said jitter detector comprising:
a first delay circuit receiving said first input signal and delaying said first input signal corresponding with said predetermined value to generate a first delayed signal;
a second delay circuit receiving said second input signal and delaying said second input signal corresponding with said predetermined value to generate a second delayed signal;
a first latch circuit latching a level of said first delayed signal corresponding with said rising edge of said second input signal to generate a first detect signal; and
a second latch circuit latching a level of said second delayed signal corresponding with said rising edge of said first input signal to generate a second detect signal.

2. The jitter detector as claimed in claim 1, wherein said first detect signal represents that said amount of jitter is smaller than said predetermined value when a level of said first detect signal becomes a first logic level, and said first detect signal represents that said amount of jitter is larger than said predetermined value when a level of said first detect signal becomes a second logic level.

3. The jitter detector as claimed in claim 1, wherein said second detect signal represents that said amount of jitter is smaller than said predetermined value when a level of said second detect signal becomes a first logic level, and said second detect signal represents that said amount of jitter is larger than said predetermined value when a level of said second detect signal becomes a second logic level.

4. A semiconductor integrated circuit comprising a phase locked loop circuit receiving an input signal and generating an output signal synchronising with said input signal, a jitter detector detecting whether a phase difference between said input signal and said output signal is smaller than a predetermined value or not.

5. The semiconductor integrated circuit as claimed in claim 4, wherein said jitter detector comprises a first delay circuit receiving said input signal and delaying said input signal corresponding with said predetermined value to generate a first delayed signal, and a first latch circuit latching a level of said first delayed signal corresponding with said output signal to generate a first detect signal.

6. The semiconductor integrated circuit as claimed in claim 5, wherein said first detect signal represents that said phase difference is smaller than said predetermined value when a level of said first detect signal becomes a first logic level, and said first detect signal represents that said phase difference is larger than said predetermined value when a level of said first detect signal becomes a second logic level.

7. The semiconductor integrated circuit as claimed in claim 5, wherein said jitter detector further comprises a second delay circuit receiving said output signal and delaying said output signal corresponding with said predetermined value to generate a second delayed signal, and a second latch circuit latching a level of said second delayed signal corresponding with said input signal to generate a second detect signal.

8. The semiconductor integrated device as claimed in claim 7, wherein said second detect signal represents that said phase difference is smaller than said predetermined value when a level of said second detect signal becomes a first logic level, and said second detect signal represents that said phase difference is larger than said predetermined value when a level of said second detect signal becomes a second logic level.

9. The semiconductor integrated circuit as claimed in claim 4, wherein said input signal has a reference frequency, said phase locked loop circuit comprises a phase comparator receiving said input and output signals and comparing a phase between said input and output signals to generate an oscillation control signal, a voltage controlled oscillator generating an oscillation signal having a first frequency which is "n" times as much as said reference frequency corresponding with said oscillation control signal, a frequency divider dividing said first frequency of said oscillation signal into "1/n" times to output said output signal.

10. The semiconductor integrated circuit as claimed in claim 4, wherein said phase locked loop circuit and said jitter detector is formed on one chip semiconductor device.
